# EUROPÄISCHE PATENTSCHRIFT

(11) **EP 0 986 817 B1**
(45) Veröffentlichungstag und Bekanntmachung des Hinweises auf die Patenterteilung: **03.03.2004**
(21) Anmeldenummer: 98966160.8
(22) Anmeldetag: 23.11.1998
(51) Int. Cl.: G11C 19/28

(54) **SCHALTUNGSANORDNUNG ALS TEIL EINES SCHIEBEREGISTERS**
CIRCUIT CONFIGURATION FORMING PART OF A SHIFT REGISTER
CONFIGURATION DE CIRCUIT UTILISEE COMME UNE PARTIE D'UN REGISTRE A DECALAGE

(30) Priorität: 17.12.1997 DE 19756039
(43) Veröffentlichungstag der Anmeldung: 22.03.2000
(73) Patentinhaber: ROBERT BOSCH GMBH, 70442 Stuttgart (DE)
(72) Erfinder: CZECHANOWSKI, Andreas, D-71034 Böblingen (DE)
(86) Internationale Anmeldenummer: PCT/DE1998/003440
(87) Internationale Veröffentlichungsnummer: WO 1999/031671

(56) Entgegenhaltungen:
- EP-A- 0 615 250
- EDWARDS M J: "NMOS AND CMOS POLYSILICON DRIVE CIRCUITS FOR LIQUID CRYSTAL DISPLAYS" IEE PROCEEDINGS: CIRCUITS DEVICES AND SYSTEMS, Bd. 141, Nr. 1, 1. Februar 1994, Seiten 50-55, XP000432044

## Beschreibung

Die Erfindung betrifft eine Schieberegisterstufe zur Ansteuerung von ketten- und matrixförmig angeordneten Schaltelementen nach dem Oberbegriff des Anspruchs 1.

### Stand der Technik

Eine Ansteuerung von ketten- oder matrixförmig angeordneten Elementen stellt insbesondere die Adressierung von Zeilen oder Spaltenleitungen eines Flüssigkristallbildschirms dar. Flüssigkristallbildschirme bestehen aus einer matrixförmigen Anordnung von Bildpunkten, wobei jedem Bildpunkt ein Schaltelement zugeordnet ist. Die Schaltelemente sind vielfach Dünnfilmtransistoren. Die Bildinformation wird an die Spalten angelegt und zeilenweise über die Schaltelemente in die Bildpunktspeicher (Bildpunkte) geschrieben. Zur Selektion der Zeilen werden regelmäßig Schieberegister eingesetzt, die vorzugsweise in derselben Technologie wie der Bildpunkt hergestellt sind.

In der Patentschrift DE 43 07 177 wird eine Schaltungsanordnung als Teil eines Schieberegisters zur Ansteuerung von ketten- oder matrixförmig angeordneten Schaltelementen offenbart. Insbesondere wird diese Schaltung zur Ansteuerung von Schaltelementen auf Zeilen einer Aktiv-Matrix für einen Flüssigkristallbildschirm eingesetzt. Erfindungsgemäß soll die Schaltung höchstens 7 als Schalter wirkende Transistoren und höchstens 2 Kapazitäten aufweisen, wobei ein Teil der Transistoren zusammen mit einer als Bootstrap-Kapazität wirkenenden Kapazität eine Ausgangsstufe bilden und mindestens ein weiterer Transistor eine Lade- und Entladestufe für die Bootstrap-Kapazität bildet. Außerdem wird die Schaltung von 4 Taktsignalen angesteuert, die jeweils um 90° gegeneinander phasenverschoben sind, so daß keine Querströme in der Schaltung auftreten. Das zur Zeilenleitung gehende Ausgangssignal hängt in dieser Schaltung unmittelbar von der Schiebetaktsignalform ab. Auf diese Weise kommt die Schaltung zwar mit wenigen Transistoren aus, jedoch ist die Ausgangssignalform im wesentlichen festgelegt.

### Vorteile der Erfindung

Der Erfindung liegt daher die Aufgabe zugrunde, eine Schieberegisterstufe bereitzustellen, mit der die ketten- oder matrixförmig angeordneten Schaltelemente effektiver bzw. variabler angesteuert werden können und dennoch eine vergleichsweise geringe Zahl von Transistoren notwendig ist.

Diese Aufgabe wird durch die Merkmale des Anspruchs 1 gelöst.

In den Unteransprüchen sind vorteilhafte und zweckmäßige Weiterbildungen der erfindungsgemäßen Schaltungsanordnung angegeben.

Die Erfindung geht von einer Schieberegisterstufe zur Ansteuerung von ketten- oder matrixförmig angeordneten Schaltelementen aus. Zur Ansteuerung der Schieberegisterstufe sind dabei 4 jeweils um 90° gegeneinander phasenverschobene Taktsignale vorhanden. Hierbei wird dem Umstand Rechnung getragen, daß bei der Adressierung von Zeilen oder Spalten einer Matrix keine beliebigen Impulssequenzen als Schiebeinformation notwendig sind. Vielmehr genügt es, einen Eingangsimpuls durch alle Stufen des Schieberegisters zu schieben, bevor der nächste Eingangsimpuls am Eingang der ersten Stufe wieder anliegt. Der Kern der Erfindung liegt nun darin, daß bei der Schieberegisterstufe wenigstens ein Transistor in Abhängigkeit von der zu schiebenden Information ein von den Schiebetaktsignalen unabhängiges Signal auf den Ausgang zur Ansteuerung der Schaltelemente durchschaltet. Diese Maßnahme hat den Vorteil, daß die durchgeschaltete Signalform auf die Bedürfnisse des Ausgangs abgestimmt werden kann. Hierdurch kann z. B. bei der Ansteuerung der Zeilen einer Aktiv-Matrix für Flüssigkristallbildschirme der Verlauf der Selektionsspannung den Eigenschaften der auf den Zeilen angeordneten Dünnschichttransistoren individuell angepaßt und dadurch ein angestrebtes Ladeverhalten der hiervon betroffenen Bildpunkte erzielt werden.

Um zu vermeiden, daß Transistoren die von unterschiedlichen Schiebetaktsignalen angesteuert werden gleichzeitig leitend sind und dadurch gegebenenfalls Querströme fließen könnten, wird vorgeschlagen, daß die um 90° gegeneinander phasenverschobenen Taktsignale im wesentlichen nicht überlappend sind.

Zur Vermeidung von unerwünschten Ausgangssignalen wird im weiteren vorgeschlagen, daß zwei Selektionssignale (111, 112) vorgesehen sind, die alternierend mit nebeneinanderliegenden Schaltungsanordnungen des Schieberegisters in Verbindung stehen und um 180° gegeneinander phasenverschobene nicht überlappende Signalformen aufweisen.

Außerdem ist es vorteilhaft, wenn die Schaltungsanordnung höchstens 8 wirkende Transistoren aufweist und diese als Schalter wirken. Damit ist die Schaltung im wesentlichen unabhängig von der Charakteristik der Transistoren im Verstärkerbereich, da der Arbeitspunkt der Transistoren im eingeschalteten Zustand stets im Anlaufbereich liegt. Durch die geringe Zahl der Transistoren von höchstens 8 wird darüber hinaus eine gute Ausbeute bei der Herstellung derartiger Schaltungen mit einem vergleichsweise geringen Platzbedarf erzielt.

Bei einer besonders günstigen Ausgestaltung der erfindungsgemäßen Schaltungsanordnung umfaßt die Schaltung im wesentlichen zwei hintereinandergeschaltete getaktete Inverter mit einer dazwischen geschalteten Ausgangsstufe. Dabei ist es bevorzugt, wenn die Inverterstufen jeweils drei in Reihe geschaltete Transistoren umfassen. Diese Anordnung hat den Vorteil, daß sich die Schaltung mit nur drei Überkreuzungen realisieren läßt, sofern man die vergleichsweise unproblematischen Überkreuzungen bei Versorgungsleitungen unberücksichtigt läßt. Vorzugsweise wird die Ausgangsstufe von wenigstens zwei Transistoren mit wenigstens einem Bootstrap-Kondensator gebildet. Durch einen ersten Transistor mit Bootstrap-Kondensator wird erreicht, daß das Selektionssignal möglichst niederohmig auf den Ausgang durchgeschaltet wird. Mit dem zweiten Transistor der Ausgangsstufe, der vorteilhafterweise ebenfalls über einen Kondensator an der Steuerelektrode verfügt, läßt sich die zu schiebende Information von der Ausgangsseite vollkommen entkoppeln. Selbst wenn der Ausgang kurzgeschlossen werden sollte, wird die zu schiebende Information im Schieberegister hierdurch nicht gestört. Die Maßnahmen führen somit insgesamt zu einer verbesserten Störsicherheit der Schaltungsanordnung.

Um eine Kompatibilität in der Herstellungstechnologie zu den Steuermatrizen einer aktiven Flüssigkristallanzeige zu erhalten, wird überdies vorgeschlagen, die Schaltung in Dünnschichttechnik herzustellen. Die Schaltungsanordnung eignet sich hierbei insbesondere zum Aufbau in amorpher Silizium-Technologie, in Poly-Silizium-Technologie aber auch in Poly-Cadmium-Selenid-Technologie. Dabei ist es vorteilhaft, wenn die Transistoren Feldeffekttransistoren vom n-MOS-Anreicherungstyp sind. Diese lassen sich in den aufgeführten Technologien besonders einfach realisieren und führen beim Anwendungsgebiet der großflächigen Dünnschichttechnik zu einem einfachen Herstellungsprozeß mit hoher Fertigungsausbeute.

Schließlich ergeben sich besondere Vorteile einer erfindungsgemäßen Schieberegisterstufe bei ihrer Verwendung zur Ansteuerung von Zeilen- und/oder Spaltenleitungen von Flüssigkristallbildschirmen.

### Zeichnungen

Ein Ausführungsbeispiel der Erfindung ist in den Zeichnungen dargestellt und in der nachfolgenden Beschreibung unter Angabe weiterer Vorteile und Einzelheiten näher erläutert.

Es zeigen
- Fig. 1: eine erfindungsgemäße Schaltungsanordnung für die n-te Stufe und n+1-te Stufe eines dynamischen Schieberegisters für eine Zeilenansteuerung und
- Fig. 2: die zeitlichen Signalverläufe verschiedener Signale für die Schaltungsanordnung nach Fig. 1.

### Ausführungsbeispiel

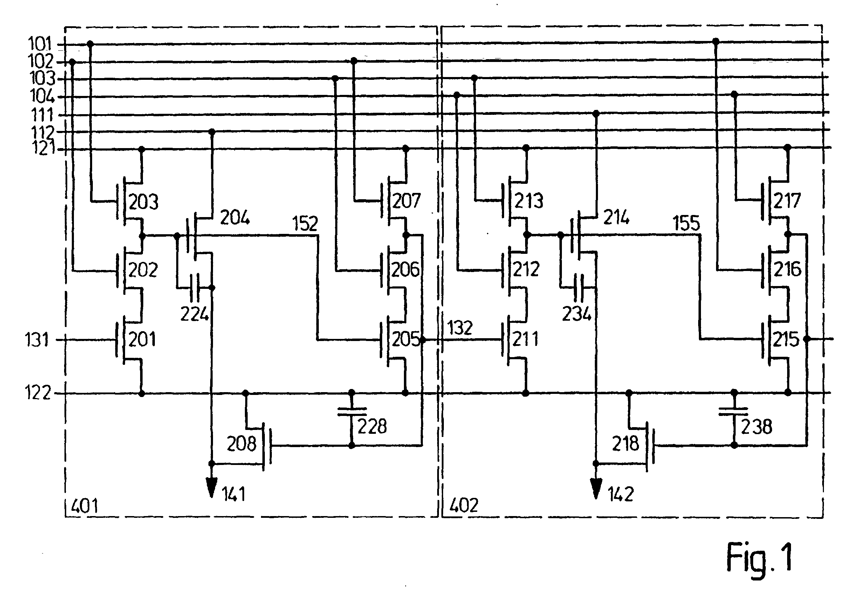

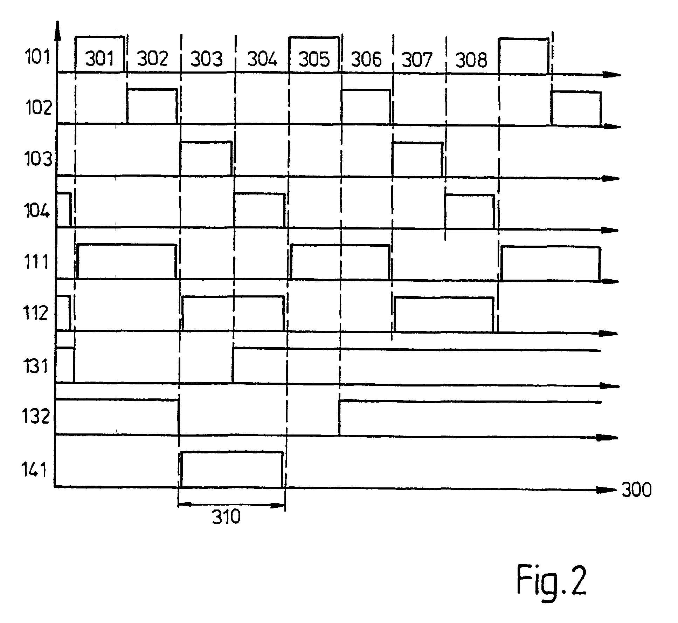

In Fig. 1 ist ein Ausführungsbeispiel einer erfindungsgemäßen Schaltungsanordnung als n-te und n+1-te Stufe eines dynamischen Schieberegisters dargestellt. Das Schieberegister wird von den vier Schiebetaktsignalen 101 bis 104 gesteuert. Wie aus dem Signaldiagramm nach Fig. 2 zu entnehmen, weisen die Schiebetaktsignale 101 bis 104 jeweils eine Phasenverschiebung von 90° zueinander auf, wobei die Einzelimpulse nicht überlappend sind. Jede Stufe wird außerdem mit einer Betriebsspannung 121, die größer Null ist, versorgt. Im weiteren sind die Schieberegisterstufen 401 sowie 402 alternierend mit zwei Selektionssignalen 111 bzw. 112 verbunden. Die Schieberegisterstufen 401 und 402 unterscheiden sich lediglich in der Zuführung der Schiebetaktsignale 101 bis 104 und der besagten Selektionssignale 111 und 112.

Die Schieberegisterstufe 401 besteht aus den Dünnschichttransistoren 201 bis 208 sowie den Kondensatoren 224 und 228. Prinzipiell kann jede Schieberegisterstufe 401 in zwei hintereinandergeschaltete, getaktete Inverter mit einer dazwischen angeordneten Ausgangsstufe aufgegliedert werden. Die Inverter umfassen jeweils drei in Reihe geschaltete Transistoren 201 bis 203 bzw. 205 bis 207. Die dazwischen geschaltete Ausgangsstufe wird durch die beiden Transistoren 208 und 204 gebildet. Neben den oben aufgeführten Signalen ist jede Stufe mit dem Massepotential 122 verbunden. Dies stellt gleichzeitig das Bezugspotential für die Spannungsangaben im Diagramm nach Fig. 2 dar. Als Schiebeinformation wird das Signal 131 bzw. 132 in die jeweilige Schieberegisterstufe eingebracht. Das Signal 132 ist gleichzeitig das Ausgangssignal aus der Stufe 401 und das Eingangssignal in die Stufe 402. Das Signal 141 ist der Ausgang der Stufe 401 zur entsprechenden Zeilenleitung, beispielsweise eines Aktiv-Matrix-Flüssigkristallbildschirms (nicht gezeigt).

Bei den Dünnschichttransistoren handelt es sich allesamt um Feldeffekttransistoren vom n-MOS-Anreicherungstyp, die durch eine positive Spannung zwischen Steuerelektrode und Kanal leitend werden und bei einer negativen oder bei fehlender Spannung zwischen Steuerelektrode und Kanal sperren.

In Fig. 2 ist die zeitliche Abfolge der einzelnen Signale dargestellt. Die Signale 101 bis 104 sind, wie bereits erwähnt, nicht überlappende Schiebetakte, die den Informationstransport im Schieberegister steuern. Die Selektionssignale 111 bzw. 112 geben die Ausgangsimpulsform für die anzusteuernde Zeilenleitung vor. Die verschiedenen Signalzustände zueinander und in zeitlicher Abfolge werden in Fig. 2 auf die Zeitintervalle 301 bis 308 bezogen. Beispielsweise ist in jedem Zustand 301 bis 308 genau eines der Signale 101 bis 104 positiv gegenüber dem Massepotential 122, während die drei anderen Signale Massepotential annehmen.

Im Zustand 301 wird der Transistor 203 durch einen positiven Impuls im Signalverlauf von 101 leitend und dadurch der Kondensator 224 aufgeladen. Durch die Spannung zwischen Steuerelektrode und dem Kanal von Transistor 204 wird dieser leitend. Das Gleiche gilt für den Transistor 205, der durch den leitenden Transistor 204 durchgeschaltet wird. Im Taktzustand 302 wird der Transistor 202 leitend. Da das Signal 131 zu diesem Zeitpunkt Massepotential führt, sperrt der Transistor 201, so daß der Kondensator 224 über die Reihenschaltung aus den Transistoren 201 und 202 sich nicht entladen kann. Gleichzeitig wird der Transistor 207 leitend und lädt den Kondensator 228 auf. Dadurch wird der Transistor 208 leitend. Somit wird der Ausgang 141 nicht nur über den Transistor 204, sondern auch über den Transistor 208 auf Massepotential gelegt.

Im Zustand 303 wird der Transistor 206 durch den positiven Spannungsverlauf von 103 leitend. Dies hat zur Folge, daß der Kondensator 228 über die Transistoren 205, der immer noch leitet und 206 wieder entladen wird, und der Transistor 208 dadurch wieder sperrt. Zur gleichen Zeit wird das Selektionssignal 112 positiv und liegt durch den immer noch leitenden Transistor 204 auch am Ausgang zur Zeilenleitung als Ausgangssignal 141 an. Durch den Bootstrap-Effekt wird über den Kondensator 224 die Steuerelektrode des Transistors 204 um den Wert der Seleketionssignalamplitude 112 positiver, wodurch gewährleistet wird, daß das Selektionssignal 112 besonders niederohmig auf die Zeilenleitung gekoppelt wird. Während des Taktzustandes 304 wird die Informationsspannung 131 positiv, wodurch der Transistor 201 leitet. Weitere Veränderungen finden nicht statt. Am Ende dieses Zustandes wird das Signal 112 wieder auf Massepotential gelegt, wodurch über den immer noch leitenden Transistor 204 das Ausgangssignal zur Zeilenleitung 141 Massepotential annimmt und die Zeilenleitung entladen wird.

Im Taktzustand 305 geschieht wieder das Gleiche wie zuvor im Taktzustand 301, jedoch mit dem Unterschied, daß der Transistor 201 aufgrund des hohen Potentials von 131 leitet. Im Zustand 306 wird nun auch der Transistor 202 leitend, so daß sich der Kondensator 224 über die beiden Transistoren 201 und 202 entlädt. Die Transistoren 204 und 205 gehen dadurch in den Sperrzustand über. Dagegen wird der Transistor 207 leitend und lädt den Kondensator 228 wieder auf, wodurch der Transistor 208 ebenfalls wieder leitend wird.

Durch diese Maßnahme wird das Ausgangssignal zur Zeilenleitung auf Massepotential gelegt, wodurch eventuelle Aufladungen auf einer Zeilenleitung abfließen können.

Im Zustand 307 wird der Transistor 206 leitend. Da jedoch der Transistor 205 sperrt, bleibt der Kondensator 228 geladen. Gleichzeitig wird die Selektionsspannung 112 positiv. Da der Transistor 204 sperrt, bleibt auch das Ausgangssignal zur Zeilenleitung 141 unbeeinflußt. Außerdem leitet der Transistor 208, wodurch das Ausgangssignal 141 auf Massepotential liegt.

Für den Taktzustand 308 ergibt sich innerhalb der Stufe 401 keine Änderung gegenüber dem vorigen Taktzustand.

In der Schieberegisterstufe 402 laufen alle beschriebenen Vorgänge um zwei Taktzustände gegenüber der Stufe 401 verzögert ab. Hier gilt also im Taktzustand 303 das Gleiche wie für die Stufe 401 im Taktzustand 301.

Die in Fig. 1 eingezeichnete Dauer 310 auf der Zeitachse 300 entspricht der Zeit, während der die Zeile aufgrund eines positiven Ausgangssignals selektiert ist.

Die beschriebene Schaltung eignet sich insbesondere für die in der Dünnschichttechnik üblichen amorphen oder polykristallinen Halbleitermaterialien wie z. B. amorphes oder polykristallines Silicium oder polykristallines Cadmium-Selenid.

## Patentansprüche

1. Schieberegisterstufe (401) zur Ansteuerung von ketten- oder matrixförmig angeordneten Schaltelementen, wobei zur Ansteuerung der Schieberegisterstufe (401) vier jeweils um 90° gegeneinander phasenverschobene Taktsignale (101 bis 104) vorgesehen sind, **dadurch gekennzeichnet, daß** wenigstens ein Transistor (204) in Abhängigkeit von einer zu schiebenden Information (131) ein von den Schiebetaktsignalen (101 bis 104) unabhängiges Signal (111, 112) auf den Ausgang (141) zur Ansteuerung der Schaltelemente durchschaltet.

2. Schieberegisterstufe nach Anspruch 1, **dadurch gekennzeichnet, daß** die jeweils um 90° gegeneinander phasenverschobenen Taktsignale (101 bis 104) sich im wesentlichen nicht überlappen.

3. Schieberegisterstufe nach einem der vorhergehenden Ansprüche, **dadurch gekennzeichnet, daß** zwei um 180° gegeneinander phasenverschobene nicht überlappende Selektionssignale (111, 112) vorgesehen sind.

4. Schieberegisterstufe nach einem der vorhergehenden Ansprüche, **dadurch gekennzeichnet, daß** höchstens 8 als Schalter wirkende Transistoren vorhanden sind.

5. Schieberegisterstufe nach einem der vorhergehenden Ansprüche, **dadurch gekennzeichnet, daß** die Schaltung im wesentlichen zwei hintereinander getaktete Inverter mit einer dazwischen geschalteten Ausgangsstufe umfaßt.

6. Schieberegisterstufe nach Anspruch 4, **dadurch gekennzeichnet, daß** die Inverterstufen jeweils 3 in Reihe geschaltete Transistoren (201 bis 203 bzw. 205 bis 207) umfassen.

7. Schieberegisterstufe nach einem der Ansprüche 4 oder 5, **dadurch gekennzeichnet, daß** die Ausgangsstufe wenigstens zwei Transistoren (204, 208) und einen Bootstrap-Kondensator (224) umfaßt.

8. Schieberegisterstufe nach einem der vorhergehenden Ansprüche, **dadurch gekennzeichnet, daß** die Schaltung in Dünnschichttechnik hergestellt ist.

9. Schieberegisterstufe nach einem der vorhergehenden Ansprüche, **dadurch gekennzeichnet, daß** die Transistoren (201 bis 208) Feldeffekttransistoren vom n-MOS-Anreicherungstyp sind.

10. Verwendung einer Schieberegisterstufe nach einem der vorhergehenden Ansprüche zur Ansteuerung von Zeilen und/oder Spalten von Flüssigkristallbildschirmen.

## Claims

1. Shift register stage (401) for driving switching elements which are arranged in concatenated or matrix form, four clock signals (101 to 104) which are each phase-shifted through 90º with respect to one another being provided for the purpose of driving the shift register stage (401), **characterized in that**, in a manner dependent on an item of information (131) to be shifted, at least one transistor (204) switches a signal (111, 112), which is independent of the shift clock signals (101 to 104), through to the output (141) for the purpose of driving the switching elements.

2. Shift register stage according to Claim 1, **characterized in that** the clock signals (101 to 104) which are each phase-shifted through 90º with respect to one another essentially do not overlap.

3. Shift register stage according to one of the preceding claims, **characterized in that** provision is made of two selection signals (111, 112) which are phase-shifted through 180º with respect to one another and do not overlap.

4. Shift register stage according to one of the preceding claims, **characterized in that** there are at most 8 transistors acting as switches.

5. Shift register stage according to one of the preceding claims, **characterized in that** the circuit essentially comprises two successively clocked inverters with an output stage connected in between them.

6. Shift register stage according to Claim 4, **characterized in that** the inverter stages each comprise 3 transistors (201 to 203 and 205 to 207) which are connected in series.

7. Shift register stage according to either of Claims 4 and 5, **characterized in that** the output stage comprises at least two transistors (204, 208) and a bootstrap capacitor (224).

8. Shift register stage according to one of the preceding claims, **characterized in that** the circuit is produced using thin film technology.

9. Shift register stage according to one of the preceding claims, **characterized in that** the transistors (201 to 208) are field effect transistors of the n-MOS enhancement-mode type.

10. Use of a shift register stage according to one of the preceding claims for driving rows and/or columns of liquid crystal display screens.

## Revendications

1. Etage de registre à décalage pour commander des éléments logiques disposés en forme de chaîne ou de matrice, avec quatre signaux de synchronisation (101 à 104) décalés à chaque fois de 90° les uns par rapport aux autres prévus pour commander l'étage du registre à décalage (401),
**caractérisé en ce qu'**
au moins un transistor (204) relie un signal (111, 112) dépendant des signaux de synchronisation à décalage (101 à 104) à la sortie (141) vers la commande des éléments logiques en fonction d'une information (131) à décaler.

2. Etage de registre à décalage selon la revendication 1,
**caractérisé en ce que**
les signaux de synchronisation (101 à 104) décalés à chaque fois de 90° les uns par rapport aux autres ne se chevauchent quasiment pas.

3. Etage de registre à décalage selon l'une quelconque des revendications précédentes,
**caractérisé par**
deux signaux sélectifs (111, 112) décalés de 180° l'un par rapport à l'autre et ne se chevauchant pas.

4. Etage de registre à décalage selon l'une quelconque des revendications précédentes,
**caractérisé par**
8 transistors maximum servant de commutateurs.

5. Etage de registre à décalage selon l'une quelconque des revendications précédentes,
**caractérisé en ce que**
la commutation comprend principalement deux inverseurs synchronisés l'un à la suite de l'autre avec un étage terminal intercalé.

6. Etage de registre à décalage selon la revendication 4,
**caractérisé en ce que**
les étages d'inverseur comprennent chacun 3 transistors en série (201 à 203 ou 205 à 207).

7. Etage de registre à décalage selon l'une quelconque des revendications 4 ou 5,
**caractérisé en ce que**
l'étage terminal comprend au moins deux transistors (204, 208) et un condensateur bootstrap (224).

8. Etage de registre à décalage selon l'une quelconque des revendications précédentes,
**caractérisé en ce que**
la commutation est créée en technique des couches minces.

9. Etage de registre à décalage selon l'une quelconque des revendications précédentes,
**caractérisé en ce que**
les transistors (201 à 208) sont des transistors à effet de champ de type enrichissement n-M.O.S.

10. Utilisation de l'étage du registre à décalage selon l'une quelconque des revendications précédentes, pour commander des lignes et/ou des colonnes des écrans à cristaux liquides.
